# EUROPEAN PATENT SPECIFICATION

(11) **EP 4 150 761 B1**
(45) Date of publication and mention of the grant of the patent: **02.09.2026**
(21) Application number: 21731290.9
(22) Date of filing: 14.05.2021
(51) Int. Cl.: H03K 3/57

(54) **APPARATUS AND METHOD FOR THE GENERATION OF HIGH INTENSITY PULSED ELECTRIC FIELDS**
VORRICHTUNG UND VERFAHREN ZUR ERZEUGUNG VON GEPULSTEN ELEKTRISCHEN FELDERN HOHER INTENSITÄT
APPAREIL ET PROCÉDÉ DE GÉNÉRATION DE CHAMPS ÉLECTRIQUES PULSÉS A HAUTE INTENSITÉ

(30) Priority: 15.05.2020 IT 202000011284
(43) Date of publication of application: 22.03.2023
(73) Proprietor: Agenzia Nazionale Per Le Nuove Tecnologie, L'Energia E Lo Sviluppo Economico Sostenibile (ENEA), 00196 Roma (IT)
(72) Inventor: BONFA', Francesca, 00157 Roma (IT); DE CARO, Salvatore, 98054 Furnari (Messina) (IT); TESTA, Antonio, 95022 Acicatena (Catania) (IT); PANARELLO, Saverio, 98142 Messina (IT); SCIMONE, Tommaso, 98166 Messina (IT)
(74) Representative: Conti, Marco
(86) International application number: PCT/IB2021/054135
(87) International publication number: WO 2021/229516

(56) References cited:
- WO-A1-2011/017802
- WO-A1-99/11771
- REDONDO L ET AL: "Analysis of a modular generator for high-voltage, high-frequency pulsed applications, using low voltage semiconductors (<1kV) and series connected step-up (1:10) transformers", REVIEW OF SCIENTIFIC INSTRUMENTS, AIP, MELVILLE, NY, US, vol. 78, no. 3, 13 March 2007 (2007-03-13), pages 34702 - 34702, XP012103847, ISSN: 0034-6748, DOI: 10.1063/1.2709743

## Description

### Technical field

This invention relates to an apparatus and a method for generating high-intensity, pulsed electric fields.

### Background art

More specifically, the apparatus and method for generating high-intensity, pulsed electric fields are used for performing a treatment to inactivate pathogenic microorganisms present in a product or for extracting substances present in the product. The product may be organic but it may also be of another nature. In other words, the apparatus is a modular apparatus for generating high-intensity, pulsed electric fields to inactivate bacteria.

Pulsed electric fields, better known as PEF, are known to be useful in the sector of apparatuses for treating organic products. The use of PEF systems allows protecting and preserving the organoleptic properties of food products while limiting energy consumption and having a low environmental impact.

These systems are based on the use of capacitive discharge, that is to say, on charging a certain number of capacitors and then discharging the energy from them to the product contained in a treatment chamber through electrodes facing the internal space m the treatment chamber. The electric shock must be considerably high in terms of energy and its entity depends substantially on the bacteria to be neutralized in the organic product and on the size of the treatment chamber. The variability of the treatment voltage required has led to an ever increasing need for flexible apparatuses that can be adapted to different applications.

Known in the prior art are solutions, such as the one described in document US2019126037A1, comprising a voltage multiplier and a voltage converter, configured to convert a direct current supply voltage to an alternating current voltage. Voltage multiplication is performed on the direct current supply voltage. Further, the output stage of the voltage multiplier has a bridge structure, thus creating a bipolar output voltage. Under equal conditions of output voltage and nominal voltage of the single electronic devices, the bridge structure of the output from the multiplier module requires a higher number of power devices. The bridge structure also increases synchronization difficulties if two or more multiplier modules are used. The solution described is therefore complex, expensive and potentially subject to malfunctioning.

In addition to the solutions mentioned above, other circuits are known for the realization of pulsed electric fields, such as those described in the scientific article REDONDO L ET AL: "Analysis of a modular generator for high-voltage, high frequency pulsed applications, using low voltage semiconductors (1kV) and series connected step-up transformers ".

In addition, documents WO2011017802A1 and WO9911771A1 illustrate a generator of SPWM waves and high-frequency square waves and a method of separating cells through the use of electric fields.

However, none of these documents describe systems that perform well in terms of system flexibility and adaptability.

### Disclosure of the invention

The invention is defined by the appended claims and relates to a modular apparatus and a method for generating high-intensity, pulsed electric fields for performing a treatment to inactivate pathogenic microorganisms present in a product or for extracting substances present in the product, to overcome the above mentioned disadvantages of the prior art.

This aim is fully achieved by the modular apparatus and the method for generating high-intensity, pulsed electric fields as characterized in the appended claims.

It should be noted that hereinafter we will refer, for simplicity, to a device and a method for generating high-intensity, pulsed electric fields. It is understood, however, that this disclosure also provides a device and a method for performing a treatment to inactivate pathogenic microorganisms present in a product or for extracting substances present in the product, by generating high-intensity, pulsed electric fields, wherein the treatment or extraction device and method comprise one or more of the features described below in connection with the device and method for generating high-intensity, pulsed electric fields.

According to claim 1 the invention provides a modular apparatus for generating high-intensity, pulsed electric fields. Preferably, the modular apparatus is used for treating products (whether organic or not). The treatment applied to the product is preferably a treatment to inactivate the pathogenic microorganisms present in the product.

The apparatus comprises a treatment chamber. The treatment chamber has an internal space in which the product to be treated (whether organic or not) can be placed. The apparatus has a converter module. The converter module is configured to receive a supply voltage, preferably direct current. The converter module is configured to convert the direct or alternating current, industrial frequency supply voltage to a high-frequency, alternating current supply voltage.

The apparatus comprises a first electrode and a second electrode. The first and second electrodes face the internal space. The first and the second electrode are spaced apart to generate an electric field in the internal space, responsive to a treatment voltage applied therein.

The apparatus comprises a multiplier module. The multiplier module is configured to rectify the supply voltage and to amplify it by a predetermined multiplication factor. This allows reaching the value of the treatment voltage starting from the supply voltage.

The apparatus comprises an interrupter module. The interrupter module is configured to enable or inhibit the treatment voltage. The interrupter module is operable to generate an electric field pulse in the internal space. In an embodiment, the multiplier module is located downstream of the converter module. That way, the multiplier module receives as input an alternating current voltage and outputs a direct current voltage whose value is the product of the multiplication factor by the amplitude of the alternating current input voltage.

This feature allows the supply voltage to be converted before it is multiplied so that conversion can be performed with voltages of lower value, which in turn means that lower performance components can be used.

In an embodiment, the multiplier module is configured to multiply the supply voltage in passive manner, that is to say, in non-controlled manner. In an embodiment, the apparatus comprises an electric circuit. The electric circuit includes the converter module, the multiplier module and the interrupter module.

In an embodiment, the interrupter module includes an SCR switch, that is to say, a single thyristor or a set of thyristors.

In an embodiment, the apparatus comprises a single interrupter module. The interrupter module is preferably also equipped with SCR devices.

The use of a component such as an SCR allows making the system reliable, highly robust and very easy to control.

In an embodiment, the apparatus comprises a first multiplier module and a second multiplier module. For clarity, it is specified that the first multiplier module is the multiplier module described up to now and the second multiplier module is an additional multiplier module. In an embodiment, the apparatus comprises three or, more generally speaking, a plurality of multiplier modules connected to each other according to a plurality of layouts.

In an embodiment, the first and the second multiplier module are connected in cascade or, in an alternative embodiment, the first and the second multiplier module are powered by separate conversion modules. In the first embodiment, the first multiplier module powers the second, since the last elementary cell of the first multiplier module and the first cell of the second multiplier module are connected in cascade. In the second embodiment, the first and the second multiplier module are, instead, powered separately by two conversion modules. In both cases, the output sections of the multipliers are connected in series and the first and second multiplier modules are each configured to multiply the supply voltage by the respective multiplication factor. In both cases, therefore, the predetermined multiplication factor can be obtained as the sum of the individual multiplication factors of the first and the second multiplier module. In an embodiment, the interrupter module is configured (designed, chosen) in such a way as to be able to control the entire part of the treatment voltage, obtained with the plurality of multiplication modules. In this embodiment, the modularity is limited to voltage multiplication. Nevertheless, this still offers advantages in terms of flexibility by making it possible to adopt an oversize interrupter module adapting the voltage by varying the number of multiplier modules.

In an embodiment, the apparatus comprises a first interrupter module and a second interrupter module. The first interrupter module and the second interrupter module are connected in series in the electric circuit to manage the treatment voltage. In essence, in a preferred embodiment, the apparatus comprises the plurality of multiplier modules and a corresponding plurality of interrupter modules, each characterized by a maximum working voltage equal to the output voltage from the respective multiplier module.

This solution allows extending the concept of modularity also to the interrupter modules so that the apparatus as a whole can be adapted to the specific application in the context of which it is used.

In an embodiment, the apparatus comprises a control unit, configured to control the interrupter module, through a command signal, as a function of which the interrupter module is activated (opened) or inactivated (closed). In an embodiment, the control unit is configured to control the first and the second interrupter module through corresponding command signals.

In an embodiment, the command signals sent by the control unit to the first interrupter module and to the second interrupter module are synchronized to allow simultaneously activating the first interrupter module and the second interrupter module. This feature is very important for the correct operation of the apparatus. In effect, without correct synchronization, the treatment voltage might not be equally divided between the first and the second interrupter module, thus overloading one of the two interrupter modules and leading to its failure.

According to the invention, the apparatus comprises an additional electric circuit.

The additional electric circuit includes an additional converter module and/or an additional multiplier module and/or an additional interrupter module.

The electric circuit comprises a first leg (first outbound leg) which connects the multiplier module to the first electrode. The electric circuit comprises a second leg (first return leg) which connects the multiplier module to the second electrode.

The additional electric circuit comprises a third leg (second outbound leg) which connects the additional multiplier module to the first electrode. The additional electric circuit comprises a fourth leg (second return leg) which connects the additional multiplier module to the second electrode.

In an embodiment, the interrupter module cuts out the first leg (first outbound leg).

In an embodiment, the electric circuit and the additional electric circuit are disposed in a first working configuration in which the additional interrupter module cuts out the third leg (second outbound leg).

This working configuration allows generating a bipolar pulse.

In an embodiment, the electric circuit and the additional electric circuit are disposed in a second working configuration in which the additional interrupter module cuts out the fourth leg.

The second configuration of the electric circuit and additional electric circuit allows varying the frequency of the pulse.

In an embodiment, the apparatus comprises an isolation transformer. The isolation transformer is mounted at an intermediate position between the voltage converter and the at least one multiplier module. In an embodiment, the converter includes the isolation transformer.

In an embodiment, the interrupter module is mounted at an intermediate position between the treatment chamber and the multiplier module.

According to claim 10 the invention provides a method for generating high-intensity, pulsed electric fields through a modular apparatus.

The method comprises a step of providing a treatment chamber having an internal space in which the product to be treated (whether organic or not) can be placed.

The method comprises a step of converting a direct current supply voltage to an alternating current supply voltage through a converter module.

The method comprises a step of providing a first electrode and a second electrode, facing the internal space and being spaced apart to generate an electric field in the internal space, responsive to a treatment voltage applied therein.

The method comprises a step of multiplying the supply voltage by a predetermined multiplication factor through the multiplier module, to reach the value of the treatment voltage starting from the supply voltage.

The method comprises a step of activating an interrupter module to enable or inhibit the treatment voltage and to generate an electric field pulse in the internal space.

In a preferred embodiment of the method, the step of multiplying is performed after the step of converting, so as to allow conversion to take place before the voltage is raised and/or to multiply the supply voltage when it is in alternating current form.

In an embodiment, in the step of activating, a single interrupter, preferably an SCR, is activated.

In an embodiment, the step of multiplying comprises a first sub-step of multiplying, in which a first multiplier module multiplies the supply voltage by a respective multiplication factor. In an embodiment, the step of multiplying comprises a second sub-step of multiplying, in which a second multiplier module multiplies the supply voltage by a respective multiplication factor. The first and the second sub-step of multiplying can be performed one after the other, or in parallel, to amplify the supply voltage by the predetermined multiplication factor, which is equal to the sum of the multiplication factors of the single multiplier modules whose output sections are connected in series.

In an embodiment, the step of activating comprises a first sub-step of activating a first interrupter module. In an embodiment, the step of activating comprises a second sub-step of activating a second interrupter module. The first and the second sub-step of activating are synchronized with each other so that each can manage a part of the full treatment voltage.

In an embodiment, the method comprises a step of controlling, in which a control unit sends command signals to the interrupter module (or to the first and second interrupter modules) for the activation thereof.

In an embodiment, the method comprises a step of providing an electric circuit, including the multiplier module, the converter module and the interrupter module. According to the invention, the method comprises a step of providing an additional electric circuit, including the additional multiplier module, the additional converter module and the additional interrupter module.

According to the invention, the method comprises connecting the multiplier module to the first electrode through a first circuit leg. According to the invention, the method comprises connecting the multiplier module to the second electrode through a second circuit leg. According to the invention, the method comprises connecting the additional multiplier module to the first electrode through a third circuit leg. According to the invention, the method comprises connecting the additional multiplier module to the second electrode through a fourth circuit leg.

In an embodiment, the method comprises a step of configuring the apparatus. In the step of configuring, the apparatus can be configured in a first configuration (bipolar pulse configuration), in which the additional interrupter module cuts out the third circuit leg. In the step of configuring, the apparatus can be configured in a second configuration (variable frequency configuration), in which the additional interrupter module cuts out the fourth circuit leg.

In an embodiment, the method comprises a step of isolating, in which an isolation transformer isolates the converter module from the multiplier module.

### Brief description of the drawings

These and other features will become more apparent from the following description of a preferred embodiment, illustrated by way of non-limiting example in the accompanying drawings, in which:

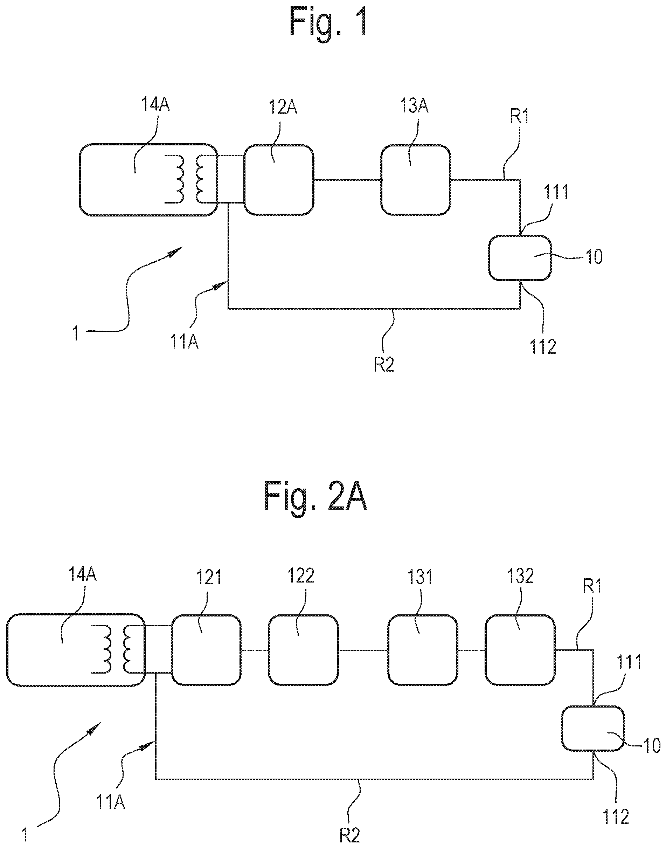

- Figure 1 schematically illustrates a modular apparatus for generating a pulsed electric field for treating organic products;

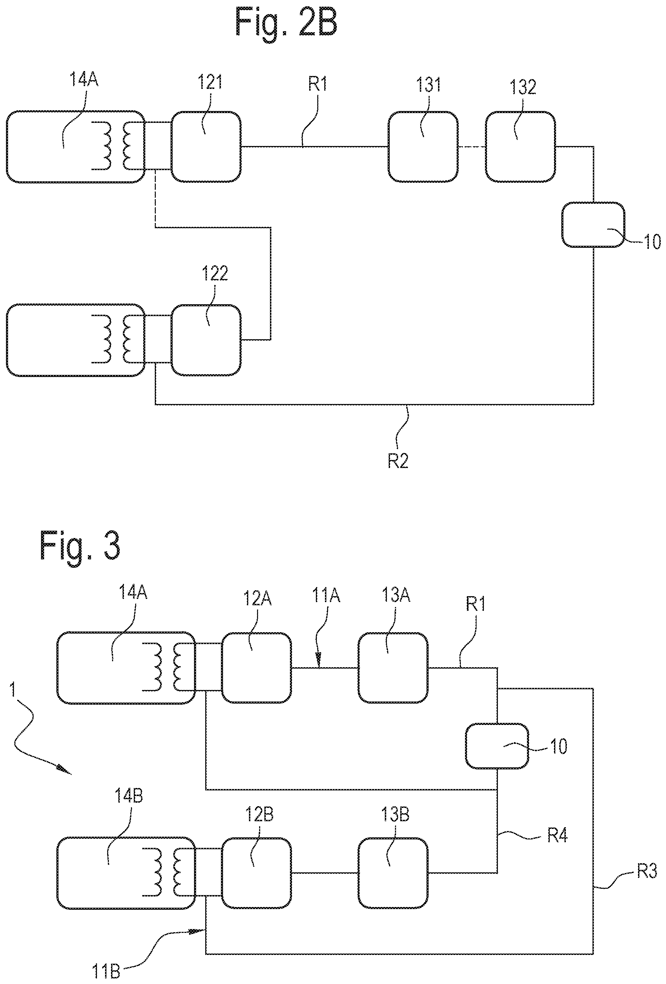

- Figures 2A and 2B schematically illustrate a first embodiment and a second embodiment of the modular apparatus of Figure 1, respectively;
- Figure 3 schematically illustrates a second embodiment of the modular apparatus of Figure 1;

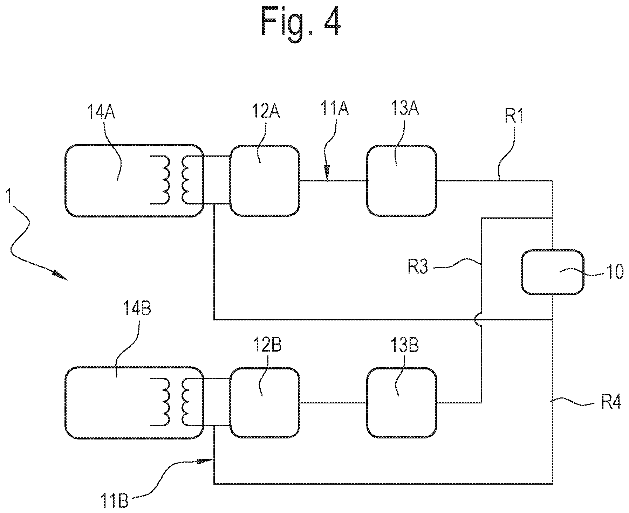

- Figure 4 schematically illustrates a third embodiment of the modular apparatus of Figure 1.

### Detailed description of preferred embodiments of the invention

With reference to the accompanying drawings, the numeral 1 denotes an apparatus for generating high-intensity pulsed electric fields for treating products (whether organic or not).

The apparatus 1 comprises a treatment chamber 10 in which the product to be treated (whether organic or not) is placed. The apparatus 1 comprises a first electrode 111 and a second electrode 112 which face the treatment chamber 10. The first and second electrodes 111, 112 thus define a kind of capacitor in which each electrode is a respective conductive surface of the capacitor.

The apparatus comprises an electric circuit 11A which is connected to the first electrode 111 and to the second electrode 112. More specifically, the electric circuit 11A comprises a first leg R1, which is connected to the first electrode 111 and a second leg R2, which is connected to the second electrode 112.

The electric circuit 11A (first converter stage) is connected to an external power supply through a power supply interface, for example, a plug that receives a supply current from the external power supply. The supply voltage with which the apparatus 1 is powered may be direct or alternating current voltage. In a preferred embodiment, however, the supply voltage is direct current voltage.

The converter module 14A is configured to provide a high frequency alternating current voltage.

In an embodiment, the electric circuit 11A comprises an isolation transformer. In an embodiment, the isolation transformer is integrated in the converter module 14A. Preferably, the isolation transformer comprises a single primary and a single secondary winding. Preferably, the number of turns of the primary winding is equal to the number of turns of the secondary winding so that the supply voltage does not undergo variations. Alternatively, in an embodiment, the transformer might, in addition to the isolation function, also be made to perform a voltage raising function by suitably calibrating the ratio between the turns of the primary winding and the turns of the secondary winding.

In an embodiment, the apparatus 1 comprises a multiplier module 12A (second multiplier stage), which is configured to rectify and raise the supply voltage by a predetermined multiplication factor. The multiplier module is preferably passive, that is to say, it does not require an active control to perform the function of multiplier.

Downstream of the multiplier module, therefore, there is a direct current voltage which reaches a value equal to a treatment voltage, depending on the type of application.

In an embodiment, the multiplier module is a diode multiplier.

In an embodiment, the apparatus 1 comprises an interrupter module 13A. The interrupter module 13A cuts out the first leg R1, enabling or inhibiting the passage of current through the first leg R1 itself.

Preventing or enabling current to pass through the first leg R1 allows generating an electric field pulse in the internal space inside the treatment chamber. For high dependability and robustness, interrupter modules including SCR switches connected in series are preferably used. The embodiment in which the interrupter module includes a plurality of SCR devices disposed in series allows avoiding the use of bridge connections, which are difficult to control and thus potentially subject to malfunctioning.

The apparatus 1 of this disclosure is a modular apparatus and thus includes a plurality of modules. In an embodiment, more generally speaking, the plurality of modules comprises one module for each function of the apparatus, that is to say, one module for multiplication (multiplier module 12A), one module for conversion (converter module 14A) and one module for generating the pulse (interrupter module 13A).

In more complex embodiments, however, the plurality of modules may comprise for each multiplication, conversion and interruption function, a plurality of multiplier modules, a plurality of converter modules and a plurality of interrupter modules, respectively. Yet other embodiments might adopt hybrid approaches, where modularity is deployed only for specific functions. For example, the apparatus 1 might comprise a plurality of multiplication modules but only one interrupter module 13A.

With such a multiplicity of modules available, the apparatus 1 may be assembled and made according to different working configurations. Described below, in particular, are three working configurations provided in this disclosure as non-limiting examples. These working configurations may also be combined with each other to obtain a combination of the respective technical effects.

In a first embodiment, used to vary the treatment voltage, the apparatus 1 comprises a first multiplier module 121 and a second multiplier module 122 to define a multiplication unit. The two multiplier modules may be connected in cascade or they may be powered independently by two converter modules. The output sections of the first and second multiplier modules 121, 122 are connected in series to amplify the supply voltage by a value equal to the sum of the multiplication factors of the first and second multiplier modules so that the multiplication factor of the multiplication unit is equal to the predetermined multiplication factor.

In the first embodiment, the apparatus also comprises a first interrupter module and a second interrupter module 131, 132 to define an interruption unit. The first and second interrupter modules 131, 132 are used to enable or inhibit the share of the treatment voltage of the corresponding first or second multiplier module 121, 122. In short, the interrupter module is configured to enable or inhibit the treatment voltage provided by the multiplication unit.

In other words, in the first embodiment, a plurality of multiplier modules 121, 122 connected in cascade or a plurality of multiplier modules 121, 122 powered by separate converter modules are used. In both cases, the output sections of the multipliers are connected in series to a corresponding plurality of interrupter modules 131, 132 connected in series. The plurality of interrupter modules 131, 132 cut out the first leg R1.

According to the invention, in a second and a third embodiment, which are configured to generate a bipolar electric field pulse and to increase the frequency of the pulse, respectively, the apparatus 1 comprises an additional electric circuit 11B which includes the same components as the electric circuit 11A. More specifically, the additional electric circuit 11B comprises an additional multiplier module 12B (an additional multiplication unit), an additional interrupter module 13B (an additional interruption unit) and an additional converter module 14B.

It is specified that like the electric circuit 11A, the additional electric circuit 11B, too, comprises two or more multiplier modules and two or more interrupter modules to form a multiplication unit and an interruption unit, respectively.

The additional electric circuit 11B comprises a third leg R3, which connects the first electrode 111 to the additional multiplier module 12B, and a fourth leg R4, which connects the second electrode 112 to the interrupter module 13B.

In the second embodiment, the additional interrupter module 13B is mounted on the fourth leg, that is to say, it cuts out a current passing through the fourth leg flowing out of the additional multiplier module 12B and into the second electrode 112. In the second embodiment, the interrupter module 13A is mounted on the first leg, that is to say, it cuts out a current passing through the first leg flowing out of the multiplier module 12A and into the first electrode 111.

In the third embodiment, the additional interrupter module 13B is mounted on the third leg, that is to say, it cuts out a current passing through the third leg flowing out of the additional multiplier module 12B and into the first electrode 111. In the third embodiment, the interrupter module 13A is mounted on the first leg, that is to say, it cuts out a current passing through the first leg flowing out of the multiplier module 12A and into the first electrode 111.

In the third embodiment, the interrupter module 13A and the interrupter module 13B are synchronized in such a way as to offset the pulses so as to increase the frequency of the treatment voltage.

That way, by suitably synchronizing the interrupter module and the additional interrupter module, the frequency of the treatment voltage pulses can be increased even by using ordinary SCR switches.

## Claims

1. A modular apparatus (1) for generating high-intensity, pulsed electric fields for performing a treatment to inactivate pathogenic microorganisms present in a product or for extracting substances present in the product, comprising:
- a treatment chamber (10), having an internal space in which the product to be treated can be placed;
- a converter module (14A), configured to receive a direct current supply voltage or an alternating current supply voltage at a first frequency and to convert it to an alternating current supply voltage at a higher frequency than that of the supply voltage received;
- a first electrode (111) and a second electrode (112), facing the internal space and being spaced apart to generate an electric field in the internal space, responsive to a treatment voltage applied therein;
- a multiplier module (12A) configured to rectify the supply voltage and to amplify it by a predetermined multiplication factor, to reach the value of the treatment voltage starting from the supply voltage;
- an interrupter module (13A) configured to enable or inhibit the treatment voltage and operable to generate an electric field pulse in the internal space, wherein the converter module (14A), the multiplier module (12A) and the interrupter module (13A) form an electric circuit which is operatively connected to the first electrode (111) and to the second electrode (112),
**characterized in that** the multiplier module (12A) is mounted downstream of the converter module (14A) to receive as input an alternating current voltage having a first amplitude and to output a direct current voltage having a second amplitude which is greater than the first amplitude,
wherein the modular apparatus (1) comprises an additional electric circuit (11B), including an additional converter module (14B), an additional multiplier module (12B) and an additional interrupter module (13B), wherein the electric circuit (11A) comprises:
- a first leg (R1), which connects the multiplier module (12A) to the first electrode (111);
- a second leg (R2), which connects the multiplier module (12A) to the second electrode (112),
and wherein the additional electric circuit (11B) comprises:
- a third leg (R3), which connects the additional multiplier module (12B) to the first electrode (111);
- a fourth leg (R4), which connects the additional multiplier module (12B) to the second electrode (112),
wherein the interrupter module (13A) cuts out the first leg (R1).

2. The modular apparatus (1) according to claim 1, comprising a first multiplier module (121) and a second multiplier module (122) mounted in cascade in the electric circuit to obtain the predetermined multiplication factor as the sum of the single multiplication factors of the first multiplier module (121) and the second multiplier module (122).

3. The modular apparatus (1) according to claim 2, comprising a first interrupter module (131) and a second interrupter module (132), mounted in series in the electric circuit (11A).

4. The modular apparatus (1) according to claim 3, comprising a control unit, configured to control the first interrupter module (131) and the second interrupter module (132) through corresponding command signals, and wherein the command signals sent by the control unit to the first interrupter module (131) and to the second interrupter module (132) are synchronized to allow simultaneously activating the first interrupter module (131) and the second interrupter module (132).

5. The modular apparatus (1) according to any one of the preceding claims, wherein the interrupter module (13A) in the electric circuit includes a single interrupter.

6. The modular apparatus (1) according to any one of the preceding claims, wherein the interrupter module (13A) includes one SCR or two or more SCRs connected in series.

7. The modular apparatus (1) according to claim 1, wherein the additional interrupter module (13B) cuts out the third leg (R3) to vary the frequency of the pulse.

8. The modular apparatus (1) according to claim 1, wherein the additional interrupter module (13B) cuts out the fourth leg (R4) to generate a bipolar pulse.

9. The modular apparatus (1) according to any one of the preceding claims, comprising an isolation transformer, mounted at an intermediate position between the voltage converter (14A) and the multiplier module (12A) and wherein the interrupter module (13A) is mounted at an intermediate position between the treatment chamber (10) and the multiplier module (12A).

10. A method for generating high-intensity, pulsed electric fields for performing a treatment to inactivate pathogenic microorganisms present in a product or for extracting substances present in the product, by means of an apparatus (1), the method comprising the following steps:
- providing a treatment chamber (10), having an internal space in which the product to be treated can be placed;
- converting, through a converter module (14A), a direct current or an alternating current supply voltage at a first frequency to an alternating current supply voltage at a higher frequency than the frequency of the supply voltage received;
- providing a first electrode (111) and a second electrode (112), facing the internal space and being spaced apart to generate an electric field in the internal space, responsive to a treatment voltage applied therein;
- rectifying the supply voltage through a multiplier module (12A);
- amplifying the supply voltage by a predetermined multiplication factor through the multiplier module (12A), to reach the value of the treatment voltage starting from the supply voltage;
- activating an interrupter module (13A) to enable or inhibit the treatment voltage and to generate an electric field pulse in the internal space,
the method being **characterized in that** the step of amplifying is performed after the step of converting to rectify and amplify the alternating current supply voltage,
wherein the method comprises a step of providing an additional electric circuit (11B), including an additional converter module (14B), an additional multiplier module (12B) and an additional interrupter module (13B), wherein the electric circuit (11A) comprises:
- a first leg (R1), which connects the multiplier module (12A) to the first electrode (111);
- a second leg (R2), which connects the multiplier module (12A) to the second electrode (112),
and wherein the additional electric circuit (11B) comprises:
- a third leg (R3), which connects the additional multiplier module (12B) to the first electrode (111);
- a fourth leg (R4), which connects the additional multiplier module (12B) to the second electrode (112),
wherein the interrupter module (13A) cuts out the first leg (R1).

## Patentansprüche

1. Modulare Vorrichtung (1) zur Erzeugung von gepulsten elektrischen Feldern hoher Intensität zur Durchführung einer Behandlung zum Inaktivieren von in einem Produkt vorhandenen pathogenen Mikroorganismen oder zum Extrahieren von im Produkt vorhandenen Substanzen, umfassend:
- eine Behandlungskammer (10) mit einem Innenraum, in den das zu behandelnde Produkt platziert werden kann;
- ein Umwandlungsmodul (14A), das so ausgelegt ist, dass es eine Gleichstrom-Versorgungsspannung oder eine Wechselstrom-Versorgungsspannung mit einer ersten Frequenz empfängt und diese in eine Wechselstrom-Versorgungsspannung mit einer höheren Frequenz als die der empfangenen Versorgungsspannung umwandelt;
- eine erste Elektrode (111) und eine zweite Elektrode (112), die dem Innenraum zugewandt sind und voneinander beabstandet sind, um im Innenraum ein elektrisches Feld zu erzeugen, das auf eine dort angelegte Behandlungsspannung anspricht;
- ein Multiplikatormodul (12A), das so ausgelegt ist, dass es die Versorgungsspannung gleichrichtet und um einen vorbestimmten Multiplikationsfaktor verstärkt, um ausgehend von der Versorgungsspannung den Wert der Behandlungsspannung zu erreichen;
- ein Unterbrechermodul (13A), das so ausgelegt ist, dass es die Behandlungsspannung ermöglicht oder sperrt, und das betätigbar ist, um im Innenraum einen elektrischen Feldimpuls zu erzeugen, wobei das Umwandlungsmodul (14A), das Multiplikatormodul (12A) und das Unterbrechermodul (13A) einen Stromkreis bilden, der betriebswirksam mit der ersten Elektrode (111) und der zweiten Elektrode (112) verbunden ist,
**dadurch gekennzeichnet, dass** das Multiplikatormodul (12A) dem Umwandlungsmodul (14A) nachgeschaltet ist, um als Eingang eine Wechselspannung mit einer ersten Amplitude zu empfangen und eine Gleichspannung mit einer zweiten Amplitude auszugeben, die größer ist als die erste Amplitude,
wobei die modulare Vorrichtung (1) einen zusätzlichen Stromkreis (11B) umfasst, einschließend ein zusätzliches Umwandlungsmodul (14B), ein zusätzliches Multiplikatormodul (12B) und ein zusätzliches Unterbrechermodul (13B) einschließt, wobei der Stromkreis (11A) Folgendes umfasst:
- einen ersten Strang (R1), der das Multiplikatormodul (12A) mit der ersten Elektrode (111) verbindet;
- einen zweiten Strang (R2), der das Multiplikatormodul (12A) mit der zweiten Elektrode (112) verbindet,
und wobei der zusätzliche Stromkreis (11B) Folgendes umfasst:
- einen dritten Strang (R3), der das zusätzliche Multiplikatormodul (12B) mit der ersten Elektrode (111) verbindet;
- einen vierten Strang (R4), der das zusätzliche Multiplikatormodul (12B) mit der zweiten Elektrode (112) verbindet,
wobei das Unterbrechermodul (13A) den ersten Strang (R1) trennt.

2. Modulare Vorrichtung (1) nach Anspruch 1, umfassend ein erstes Multiplikatormodul (121) und ein zweites Multiplikatormodul (122), die im Stromkreis in einer Kaskade angeordnet sind, um den vorbestimmten Multiplikationsfaktor als Summe der einzelnen Multiplikationsfaktoren des ersten Multiplikatormoduls (121) und des zweiten Multiplikatormoduls (122) zu erhalten.

3. Modulare Vorrichtung (1) nach Anspruch 2, umfassend ein erstes Unterbrechermodul (131) und ein zweites Unterbrechermodul (132), die in Reihe im Stromkreis (11A) geschaltet sind.

4. Modulare Vorrichtung (1) nach Anspruch 3, umfassend eine Steuereinheit, die so ausgelegt ist, dass sie das erste Unterbrechermodul (131) und das zweite Unterbrechermodul (132) über entsprechende Befehlssignale steuert, und wobei die Befehlssignale, die von der Steuereinheit an das erste Unterbrechermodul (131) und an das zweite Unterbrechermodul (132) gesendet werden, synchronisiert sind, um ein gleichzeitiges Aktivieren des ersten Unterbrechermoduls (131) und des zweiten Unterbrechermoduls (132) zu ermöglichen.

5. Modulare Vorrichtung (1) nach einem der vorhergehenden Ansprüche, wobei das Unterbrechermodul (13A) im Stromkreis einen einzelnen Unterbrecher einschließt.

6. Modulare Vorrichtung (1) nach einem der vorhergehenden Ansprüche, wobei das Unterbrechermodul (13A) einen SCR oder zwei oder mehr in Reihe geschaltete SCRs einschließt.

7. Modulare Vorrichtung (1) nach Anspruch 1, wobei das zusätzliche Unterbrechermodul (13B) den dritten Strang (R3) trennt, um die Frequenz des Impulses zu variieren.

8. Modulare Vorrichtung (1) nach Anspruch 1, wobei das zusätzliche Unterbrechermodul (13B) den vierten Strang (R4) trennt, um einen bipolaren Impuls zu erzeugen.

9. Modulare Vorrichtung (1) nach einem der vorhergehenden Ansprüche, umfassend einen Trenntransformator, der an einer Zwischenposition zwischen dem Spannungswandler (14A) und dem Multiplikatormodul (12A) angebracht ist, und wobei das Unterbrechermodul (13A) an einer Zwischenposition zwischen der Behandlungskammer (10) und dem Multiplikatormodul (12A) angebracht ist.

10. Verfahren zur Erzeugung von gepulsten elektrischen Feldern hoher Intensität zur Durchführung einer Behandlung zum Inaktivieren von in einem Produkt vorhandenen pathogenen Mikroorganismen oder zum Extrahieren von im Produkt vorhandenen Substanzen mittels einer Vorrichtung (1), wobei das Verfahren die folgenden Schritte umfasst:
- Bereitstellen einer Behandlungskammer (10) mit einem Innenraum, in den das zu behandelnde Produkt platziert werden kann;
- Umwandeln, durch ein Umwandlungsmodul (14A), einer Gleichstrom- oder einer Wechselstrom-Versorgungsspannung mit einer ersten Frequenz in eine Wechselstrom-Versorgungsspannung mit einer höheren Frequenz als die Frequenz der empfangenen Versorgungsspannung;
- Bereitstellen einer ersten Elektrode (111) und einer zweiten Elektrode (112), die dem Innenraum zugewandt sind und voneinander beabstandet sind, um im Innenraum ein elektrisches Feld zu erzeugen, das auf eine dort angelegte Behandlungsspannung anspricht;
- Gleichrichten der Versorgungsspannung über ein Multiplikatormodul (12A);
- Verstärken der Versorgungsspannung um einen vorbestimmten Multiplikationsfaktor durch das Multiplikatormodul (12A), um ausgehend von der Versorgungsspannung den Wert der Behandlungsspannung zu erreichen;
- Aktivieren eines Unterbrechungsmoduls (13A), um die Behandlungsspannung zu ermöglichen oder zu sperren und einen elektrischen Feldimpuls im Innenraum zu erzeugen, wobei das Verfahren **dadurch gekennzeichnet ist, dass** der Schritt zum Verstärken nach dem Schritt zum Umwandeln durchgeführt wird, um die Wechselstrom-Versorgungsspannung gleichzurichten und zu verstärken,
wobei das Verfahren einen Schritt zum Bereitstellen eines zusätzlichen Stromkreises (11B) umfasst, einschließend ein zusätzliches Umwandlungsmodul (14B), ein zusätzliches Multiplikatormodul (12B) und ein zusätzliches Unterbrechermodul (13B), wobei der Stromkreis (11A) Folgendes umfasst:
- einen ersten Strang (R1), der das Multiplikatormodul (12A) mit der ersten Elektrode (111) verbindet;
- einen zweiten Strang (R2), der das Multiplikatormodul (12A) mit der zweiten Elektrode (112) verbindet;
und wobei der zusätzliche Stromkreis (11B) Folgendes umfasst:
- einen dritten Strang (R3), der das zusätzliche Multiplikatormodul (12B) mit der ersten Elektrode (111) verbindet;
- einen vierten Strang (R4), der das zusätzliche Multiplikatormodul (12B) mit der zweiten Elektrode (112) verbindet,
wobei das Unterbrechermodul (13A) den ersten Strang (R1) trennt.

## Revendications

1. Appareil modulaire (1) de génération de champs électriques pulsés à haute intensité pour effectuer un traitement visant à inactiver des micro-organismes pathogènes présents dans un produit ou pour extraire des substances présentes dans le produit, comprenant :
- une chambre de traitement (10), ayant un espace interne dans lequel le produit à traiter peut être placé ;
- un module convertisseur (14A), configuré pour recevoir une tension d'alimentation en courant continu ou une tension d'alimentation en courant alternatif à une première fréquence et pour la convertir en une tension d'alimentation en courant alternatif à une fréquence supérieure à celle de la tension d'alimentation reçue ;
- une première électrode (111) et une seconde électrode (112), faisant face à l'espace interne et étant espacées pour générer un champ électrique dans l'espace interne, en réponse à une tension de traitement qui y est appliquée ;
- un module multiplicateur (12A) configuré pour redresser la tension d'alimentation et l'amplifier d'un facteur de multiplication prédéterminé, pour atteindre la valeur de la tension de traitement à partir de la tension d'alimentation ;
- un module interrupteur (13A) configuré pour activer ou inhiber la tension de traitement et utilisable pour générer une impulsion de champ électrique dans l'espace interne, dans lequel le module convertisseur (14A), le module multiplicateur (12A) et le module interrupteur (13A) forment un circuit électrique qui est connecté de manière opérationnelle à la première électrode (111) et à la seconde électrode (112),
**caractérisé en ce que** le module multiplicateur (12A) est monté en aval du module convertisseur (14A) pour recevoir en entrée une tension de courant alternatif ayant une première amplitude et pour délivrer en sortie une tension de courant continu ayant une seconde amplitude qui est supérieure à la première amplitude,
dans lequel l'appareil modulaire (1) comprend un circuit électrique supplémentaire (11B), incluant un module convertisseur supplémentaire (14B), un module multiplicateur supplémentaire (12B) et un module interrupteur supplémentaire (13B), dans lequel le circuit électrique (11A) comprend :
- une première branche (R1), qui connecte le module multiplicateur (12A) à la première électrode (111) ;
- une deuxième branche (R2), qui connecte le module multiplicateur (12A) à la seconde électrode (112),
et dans lequel le circuit électrique supplémentaire (11B) comprend :
- une troisième branche (R3), qui connecte le module multiplicateur supplémentaire (12B) à la première électrode (111) ;
- une quatrième branche (R4), qui connecte le module multiplicateur supplémentaire (12B) à la seconde électrode (112),
dans lequel le module interrupteur (13A) déconnecte la première branche (R1).

2. Appareil modulaire (1) selon la revendication 1, comprenant un premier module multiplicateur (121) et un second module multiplicateur (122) montés en cascade dans le circuit électrique pour obtenir le facteur de multiplication prédéterminé en tant que somme des facteurs de multiplication uniques du premier module multiplicateur (121) et du second module multiplicateur (122).

3. Appareil modulaire (1) selon la revendication 2, comprenant un premier module interrupteur (131) et un second module interrupteur (132), montés en série dans le circuit électrique (11A).

4. Appareil modulaire (1) selon la revendication 3, comprenant une unité de commande, configurée pour commander le premier module interrupteur (131) et le second module interrupteur (132) par l'intermédiaire de signaux de commande correspondants, et dans lequel les signaux de commande envoyés par l'unité de commande au premier module interrupteur (131) et au second module interrupteur (132) sont synchronisés pour permettre l'activation simultanée du premier module interrupteur (131) et du second module interrupteur (132).

5. Appareil modulaire (1) selon l'une quelconque des revendications précédentes, dans lequel le module interrupteur (13A) dans le circuit électrique inclut un seul interrupteur.

6. Appareil modulaire (1) selon l'une quelconque des revendications précédentes, dans lequel le module interrupteur (13A) inclut un SCR ou deux SCR ou plus connectés en série.

7. Appareil modulaire (1) selon la revendication 1, dans lequel le module interrupteur supplémentaire (13B) déconnecte la troisième branche (R3) pour faire varier la fréquence de l'impulsion.

8. Appareil modulaire (1) selon la revendication 1, dans lequel le module interrupteur supplémentaire (13B) déconnecte la quatrième branche (R4) pour générer une impulsion bipolaire.

9. Appareil modulaire (1) selon l'une quelconque des revendications précédentes, comprenant un transformateur d'isolation, monté dans une position intermédiaire entre le convertisseur de tension (14A) et le module multiplicateur (12A), et dans lequel le module interrupteur (13A) est monté dans une position intermédiaire entre la chambre de traitement (10) et le module multiplicateur (12A).

10. Procédé de génération de champs électriques pulsés à haute intensité pour effectuer un traitement visant à inactiver des micro-organismes pathogènes présents dans un produit ou pour extraire des substances présentes dans le produit, au moyen d'un appareil (1), le procédé comprenant les étapes suivantes :
- fournir une chambre de traitement (10), ayant un espace interne dans lequel le produit à traiter peut être placé ;
- convertir, par l'intermédiaire d'un module convertisseur (14A), une tension d'alimentation en courant continu ou en courant alternatif à une première fréquence en une tension d'alimentation en courant alternatif à une fréquence supérieure à la fréquence de la tension d'alimentation reçue ;
- fournir une première électrode (111) et une seconde électrode (112), faisant face à l'espace interne et étant espacées pour générer un champ électrique dans l'espace interne, en réponse à une tension de traitement qui y est appliquée ;
- redresser la tension d'alimentation à travers un module multiplicateur (12A) ;
- amplifier la tension d'alimentation d'un facteur de multiplication prédéterminé à travers le module multiplicateur (12A), pour atteindre la valeur de la tension de traitement à partir de la tension d'alimentation ;
- activer un module interrupteur (13A) pour activer ou inhiber la tension de traitement et générer une impulsion de champ électrique dans l'espace interne,
le procédé étant **caractérisé en ce que** l'étape d'amplifier est effectuée après l'étape de convertir pour redresser et amplifier la tension d'alimentation en courant alternatif,
dans lequel le procédé comprend une étape de fournir un circuit électrique supplémentaire (11B), incluant un module convertisseur supplémentaire (14B), un module multiplicateur supplémentaire (12B) et un module interrupteur supplémentaire (13B), dans lequel le circuit électrique (11A) comprend :
- une première branche (R1), qui connecte le module multiplicateur (12A) à la première électrode (111) ;
- une deuxième branche (R2), qui connecte le module multiplicateur (12A) à la seconde électrode (112),
et dans lequel le circuit électrique supplémentaire (11B) comprend :
- une troisième branche (R3), qui connecte le module multiplicateur supplémentaire (12B) à la première électrode (111) ;
- une quatrième branche (R4), qui connecte le module multiplicateur supplémentaire (12B) à la seconde électrode (112),
dans lequel le module interrupteur (13A) déconnecte la première branche (R1).
